# EUROPEAN PATENT APPLICATION

(11) **EP 2 117 288 A1**
(43) Date of publication of application: **11.11.2009**
(21) Application number: 08155830.6
(22) Date of filing: 07.05.2008
(51) Int. Cl.: H05K 7/20, H01L 23/427

(54) **Heat-management system for a cabinet containing electronic equipment**

(71) Applicant: 3M Innovative Properties Company, St. Paul MN 55144-1000 (US)
(72) Inventor: Denter, Friedrich, 44575 Castrop-Rauxel (DE); Anders, Herbert, 44309 Dortmund (DE); Bauer, Dr. Manfred, 42119 Wuppertal (DE)
(74) Representative: Bergen, Katja

(57) **Abstract**

A heat-management system is described for use in a cabinet containing electronic equipment (15) that produces a flow of heated air when in operation. The system comprises: an evaporator (32) positioned in the path of a heated air flow produced by the said equipment, to take up heat therefrom; a condenser (34) positioned above the evaporator in the path of a flow of cooling air, to transfer heat to the ambient air outside the cabinet; and a heat pipe 36 connecting the evaporator directly to the condenser to transport heat from the evaporator to the condenser.

## Description

The present invention relates to cabinets used for housing electronic equipment, for example, telecommunications equipment.

Cabinets are used to provide a closed environment to protect sensitive electronic equipment. Depending on the nature of the equipment and its location, protection may be required against factors such as environmental conditions, pollution, tampering and even vandalism. In telecommunications networks, for example, outdoor cabinets have conventionally been used to house passive cross-connect telecommunications modules at distribution points where, for example, local subscriber lines can be connected to cables that run to a central office. Such cabinets are often located at street level but may also be mounted on poles or on the walls or roofs of buildings. Cabinets may also be used to house electronic equipment in an indoor environment, for example at a telecommunications distribution point located in an office building or a particular floor of an office building.

The internal compartment of a telecommunications cabinet typically comprises a carrier in the form of rails, racks, panels, and/or frames (or similar components) on which the telecommunications equipment is mounted. Cabinets of that type are described, for example, in US-A-5 467 250 (Howard et al.); US-A-2004/114326 (Dodgen et al); and WO 02/32202 (Vidacovich et al).

The nature of electronic equipment that is being housed in cabinets continues to change and, as a result, the functional requirements that are being placed on the cabinets themselves are also changing. For example, following the spread of xDSL (digital subscriber line)-technology in the field of telecommunications, telecommunications cabinets are increasingly being used to house active, as well as passive, telecommunications equipment. The active equipment includes, for example, Digital Subscriber Line Access Multiplexers (DSLAMs) which process data signals, and Multi-Service Access Nodes (MSANs) which process voice as well as data signals.

As the amount of active equipment housed in a cabinet increases, the amount of heat generated within the cabinet also increases. Excess heat must be removed in order to protect the equipment within the cabinet and various systems have been proposed for that purpose (see, for example, WO 01/015507 (Tikka); WO 00/062590 (Berger et al); and the above-mentioned US-A-2004/0114326 and WO 02/032202).

With a view to reducing the power consumption of the heat removal systems of telecommunications cabinets and, in some cases, the noise generated by those systems it has also been proposed that heat pipes should be used to transfer heat from one location to another within the system (see, for example, US-A-6 603 660 (Ehn et al); WO 03/065781(Tsoi); WO 03/009663 (Hoover et al); and WO 00/014469 (Mannerjoki)). WO 03/009663, for example, describes a thermal energy management architecture for a functioning system of electronic components and subsystems in which thermal management components are substantially only thermally driven. In one case, a flexible heat pipe is used to transport heat, from an evaporator plate fastened to a high power electronic component, to a condenser plate connected to the evaporator of a thermosyphon.

There remains a need for a heat removal system that is not only suitable for use in newly-built cabinets for housing electronic equipment but can also be installed, as required, in cabinets that are already in use. The present invention has been made with that need in mind.

The present invention provides a heat-management system for use in a cabinet containing electronic equipment that produces a flow of heated air when in operation, the system comprising:
an evaporator constructed to be positioned in the path of a heated air flow produced by the said equipment, to take up heat therefrom;
a condenser constructed to be positioned above the evaporator in the path of a flow of cooling air, to transfer heat to the ambient air outside the cabinet; and a heat pipe to connect the evaporator directly to the condenser to transport heat from the evaporator to the condenser.

The term "heat pipe" as used herein refers to a hollow tube forming a connection between an evaporator portion and a condenser portion of a sealed system that contains a heat-transfer fluid; the connection being such that, if heat is applied to the heat-transfer fluid (in the liquid phase) in the evaporator portion of the system, the heat is transferred through the medium of the heat-transfer fluid (in the liquid and/or the vapour phase) to the condenser portion of the system where it can be removed, following which the cooled heat-transfer fluid returns to the evaporator portion. The return flow of the heat-transfer fluid to the evaporator portion may occur either as a result of a capillary action imparted by the heat pipe or, if the heat pipe is vertically-oriented, under the influence of gravity.

The invention is applicable to cabinets containing electronic equipment that produces a flow of heated air when in operation, for example because it comprises an air-flow generator (e.g. a fan or a blower) operable to cause a flow of cooling air over the equipment. Active electronic equipment typically incorporates its own cooling mechanism in the form of a fan or a blower, and the invention may then involve using the path of the resulting flow of heated air as a location for the evaporator of the heat management system, thereby avoiding the need to position the evaporator directly on the active electronic equipment within the cabinet. Installation of the system within a cabinet that is already in use is thereby facilitated, and can be further assisted if at least part of the heat pipe is flexible whereby the position of the evaporator relative to the active equipment can be adjusted. Alternatively, a suitable air-flow generator can be separately provided, if required, at an appropriate location within the cabinet to cause a flow of cooling air over the active electronic equipment.

The location of the condenser above the evaporator in a system in accordance with the invention enables the transfer of heat within the system through the medium of the heat-transfer fluid to take place without the need for a pump (thereby avoiding the realated energy consumption and noise) and without the need for a heat pipe having a wick structure to promote the return flow of heat-transfer fluid from the condenser to the evaporator.

A system in accordance with the invention can be used with advantage in a cabinet that is already configured to produce a flow of cooling air in which the condenser of the system can be located to transfer heat to the ambient air outside the cabinet. In some cabinets, for example, the walls are of a double-shell construction forming an air space around the internal compartment(s) of the cabinet intended to promote a flow of cooling air around the internal compartment(s) as a result of natural convection. As an alternative, or in addition, some cabinets incorporate fans intended to promote a flow of cooling air through the internal compartment as a result of forced convection. One suitable location for the condenser of a heat-management system in accordance with the invention is in the roof of a cabinet, although that is not essential.

The heat-transfer fluid employed in a system in accordance with the invention should be selected having regard to the operating temperatures to which the system will be exposed in use and the amount of heat to be dissipated. As with all heat pipe systems, there will be an optimum level to which a system in accordance with the invention should be filled with the heat-transfer fluid, in the liquid phase, to ensure efficient heat transfer. Typically the heat-transfer system will be more than 50% filled, by volume, with heat-transfer fluid in the liquid phase but not completely filled. The optimum fill level can be determined by experimentation, and will typically be a level at which heat transfer from the evaporator of the system to the condenser occurs through the medium of the heat-transfer fluid in both the liquid and the vapour phase.

The components of a heat-management system in accordance with the invention may be provided separately. Preferably, however, the system is provided already assembled and containing the heat-transfer fluid. The system preferably allows for the addition of further components e.g. one or more additional evaporator and/or one or more additional condenser.

The evaporator and condenser may be of any suitable form and may be of similar construction. One suitable form is a radiator, which may be of similar construction to the liquid-filled radiators used to cool internal combustion engines of vehicles.

Any suitable hollow tube may be used for the heat pipe of the system, for example hydraulic brake hose.

A system in accordance with the invention may further include means for mounting the evaporator and/or condenser of the system in a cabinet containing electronic equipment. In the case of a telecommunications cabinet, for example, the system may include components suitable for mounting the evaporator and/or condenser on the racks that are already present in the cabinet for mounting the telecommunications equipment.

By way of example, heat management systems in accordance with the invention will be described with reference to the accompanying drawings, in which:
Fig. 1 shows an example of an outdoor cabinet as used in a telecommunications system;
Fig. 2 shows the interior of the cabinet of Fig. 1;
Fig. 3 is a diagrammatic illustration of one possible layout of telecommunications equipment inside the cabinet;
Fig. 4 is a diagrammatic illustration of a heat management system in accordance with the invention;
Fig. 5 shows the heat management system of Fig. 4 installed in an outdoor cabinet of a telecommunications system;
Fig. 6 shows components of the heat management system of Fig. 4; and
Figs. 7 to 11 illustrate modifications of the heat management system of Fig. 4.

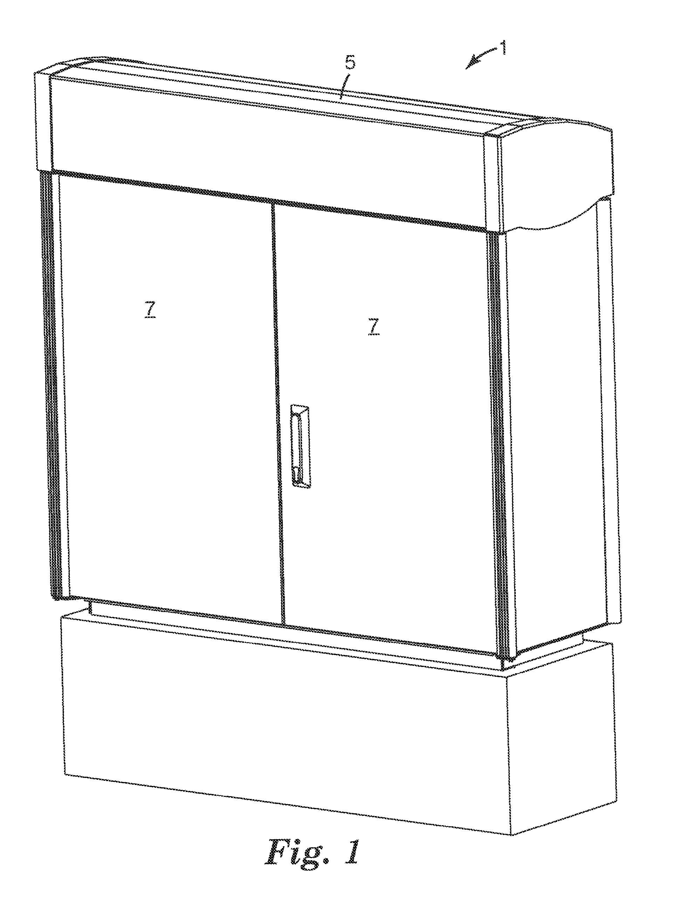

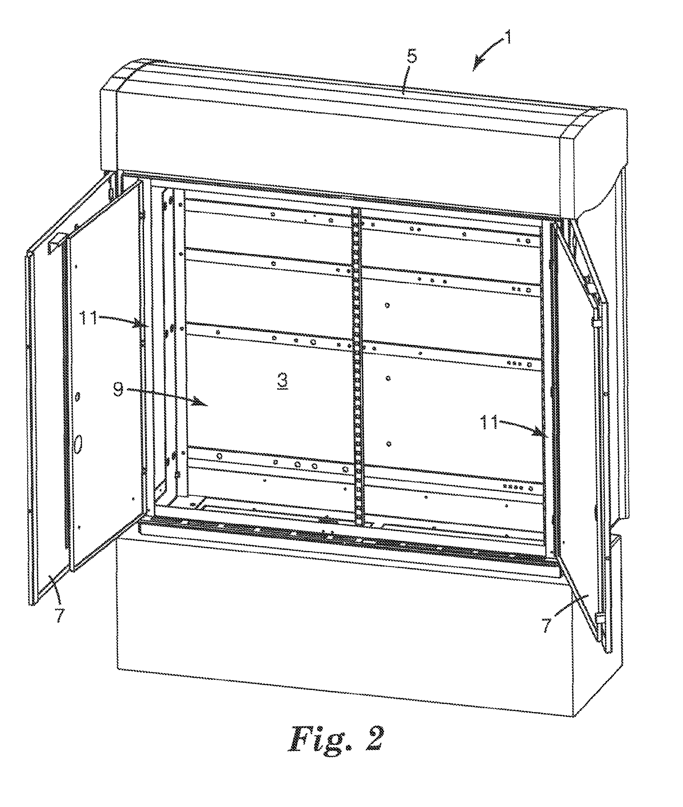

Figs. 1 and 2 show a cabinet, in this case, an outdoor cabinet 1 of a telecommunications system, in which a heat management system in accordance with the invention can be installed. The cabinet illustrated can be stood on a suitable platform or mounted on a pole or the wall of a building, as required, and has a rear wall 3 (not visible in Fig 1), a roof 5, and doors 7 which, when closed, form the front wall of the cabinet. The doors 7 open, as shown in Fig. 2, to reveal a compartment 9 containing racks 11 on which telecommunications equipment such as termination blocks and DSLAMs can be mounted so that they are accessible for installation and maintenance purposes. In some cases, a cabinet may comprise more than one internal compartment.

As is well known, outdoor cabinets for telecommunications systems can take many forms of which the cabinet shown in Figs. 1 and 2 is just one example. Similar cabinets can also be used, outside the field of telecommunications, for housing electronic components. Examples of other cabinets include switch cabinets, energy distribution cabinets, and cabinets that house electronic traffic control equipment.

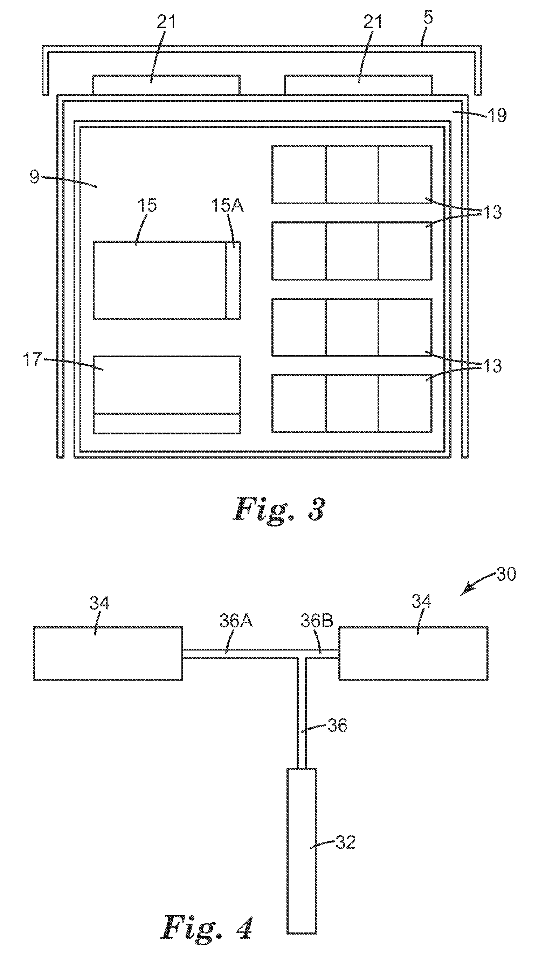

Fig. 3 illustrates, diagrammatically, one possible arrangement of telecommunications modules in the internal compartment 9 of an outdoor cabinet. In this case, passive equipment in the form of an array of termination blocks 13 is shown in one part of the compartment 9, and active equipment in the form of a DSLAM 15 is shown in another part of the compartment together with a power supply 17. The DSLAM module 15 includes a fan 15A that generates a flow of cooling air over the module 15.

The cabinet illustrated in Fig. 3 has a conventional double-shell construction forming an air-space 19 around the internal compartment 9 to provide thermal isolation against solar radiation. When the cabinet is in use, heat generated by the active equipment 15 and the power supply 17 will be dissipated to some extent by natural convection within the compartment 9 and also within the surrounding air-space 19 provided by the double-shell construction of the cabinet. If additional heat needs to be dissipated, one or more fans 21 can be provided in the roof 5 of the cabinet to enhance the flow of air through the compartment 9.

The increasing use of active equipment in outdoor cabinets such as that shown in Fig. 3 is resulting in a need to remove greater amounts of heat from the internal compartment(s) 9 to ensure that the equipment housed within a cabinet is not exposed to temperatures that could adversely affect its operation. In many cases, this can no longer be achieved by relying on the heat-dissipation mechanisms described above.

Fig. 4 illustrates a heat-management system 30 that can be installed in the cabinet of Fig. 3 to increase the amount of heat removed from the compartment 9. The system 30 comprises an evaporator 32, two condensers 34, and a heat pipe 36 (with branches 36A, 36B) connecting the evaporator 32 directly to the condensers 34. The system contains a heat-transfer liquid and is sealed. The system 30 may be intended to function as a one-phase system in which, if heat is applied to the evaporator 32, the heated heat-transfer liquid moves along the heat pipe 36 to the condensers 34 where it gives up its heat and returns to the evaporator 32. Alternatively, the system 30 may be intended to function as a two-phase system in which, if heat is applied to the evaporator 32 to vaporize the heat-transfer liquid, the vapour moves along the heat pipe 36 to the condensers 34 where it gives up its heat and condenses back to the liquid phase which then returns to the evaporator 32. In some cases, heated heat-transfer liquid may also move with the vapour along the heat pipe to the condensers 34 where it will also give up its heat and return to the evaporator 32. In both types of system, the heat-transfer liquid returns to the evaporator 32 either as a result of a wicking action imparted by the heat pipe 36 or, if the heat pipe is vertically-oriented, under the influence of gravity. Heat pipes, and the way in which they operate, are well known.

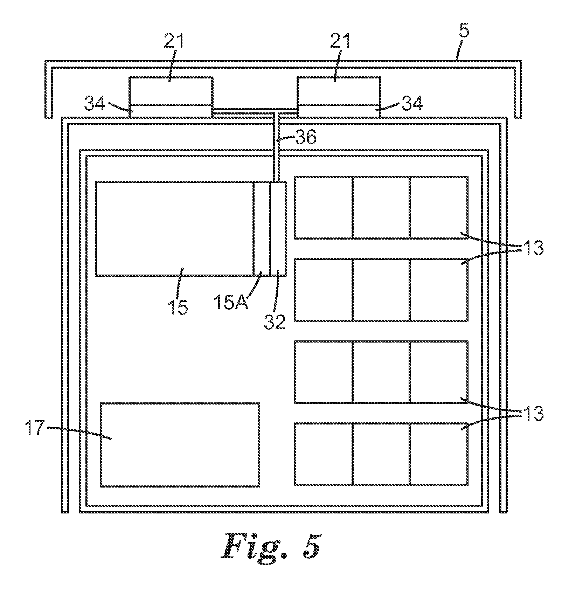

Fig. 5 shows the heat-management system 30 installed in the cabinet of Fig. 3. The evaporator 32 is located in the flow of heated air produced from the DSLAM 15 by the fan 15A, and the condensers 34 are positioned in a flow of cooling air in the roof 5 of the cabinet, for example in the air intake of the fans 21 (when present) or in the air flow due to natural convection within the cabinet. The heat pipe 36 is oriented substantially vertically. The system will then function as just described to transfer the heat taken up by the evaporator 32 to the condensers 34, from which it will be transferred to the exterior. The evaporator 32 and the condensers 34 can be mounted in the cabinet in any suitable way but preferably make use of the racks 11 that are already present within the cabinet using, for example, mounting screws similar to those that are used to attach the telecommunications equipment within the cabinet.

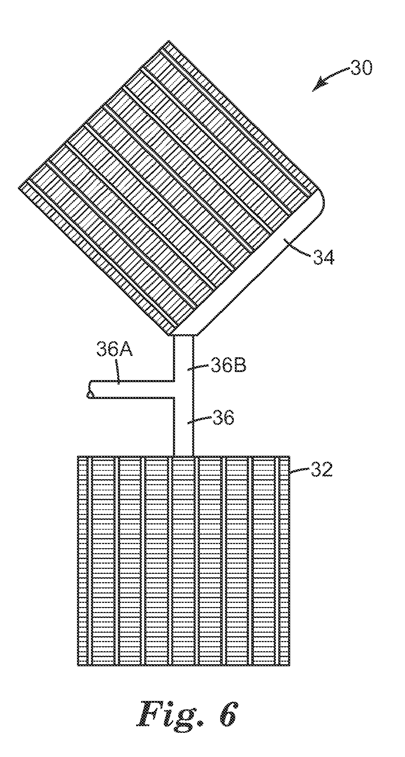

The evaporator 32 and the condensers 34 may be of any suitable known type and may be of identical construction. An example of a suitable construction is a radiator of the liquid-filled type used in the cooling system of internal combustion engines in vehicles having a plurality of cooling fins. Fig. 6 shows such radiators used as the evaporator 32 and condensers 34 (only one shown) of the system of Fig. 4. Radiators of that type are increasingly being used for cooling personal computers (PCs) as the heat output of those devices increases, and are now available in efficient, compact forms with dimensions suitable for use in cabinets housing electronic equipment. An example of a radiator suitable for use in a system in accordance with the invention is available under the trade name "Black Ice" from Hardware Labs of Quezon City, Philippines.

The heat pipe 36 may also be of any suitable known type, advantageously a simple type that does not provide a wicking action because the pipe will normally be oriented substantially vertically and can rely on gravity for its correct operation. Conventional hydraulic hose can be used for the heat pipe, suitable products being available from Continental Automotive Systems of Frankfurt am Main, Germany.

The heat-transfer fluid used in the heat-management system 30 may be of any type known to be suitable for use in heat pipes, selected having regard to the likely operating temperatures of the system. Heat-transfer fluids are described, for example, in WO/98/37163 (Owens et al) and WO 99/41428 ( Owens and Anome). The heat transfer fluid may comprise a hydrofluoroether, for example methyl perfluoropropyl ether. A particularly suitable heat-transfer fluid is Novec™ Engineered Fluid HFE-7100, available from 3M Company of St. Paul, Minnesota, USA. That particular fluid has numerous advantageous characteristics that make it a preferred choice for use in the system 30: for example, it has zero ozone depletion potential, good materials compatibility, good thermal stability and low toxicity; and is non-flammable and noncorrosive.

The heat-transfer fluid is put into the heat-management system 30 in liquid form and the system is then sealed. When the system is intended to function as a two-phase system, the liquid will not fill the system completely, to allow for vaporization, but will typically occupy more than 50% of the volume of the system. The optimum amount of fluid to ensure efficient operation of the system can be determined by experimentation and will typically be a level at which heat transfer from the evaporator 32 to the condensers 34 occurs through the medium of the heat-transfer fluid in both the liquid and the vapour phase.

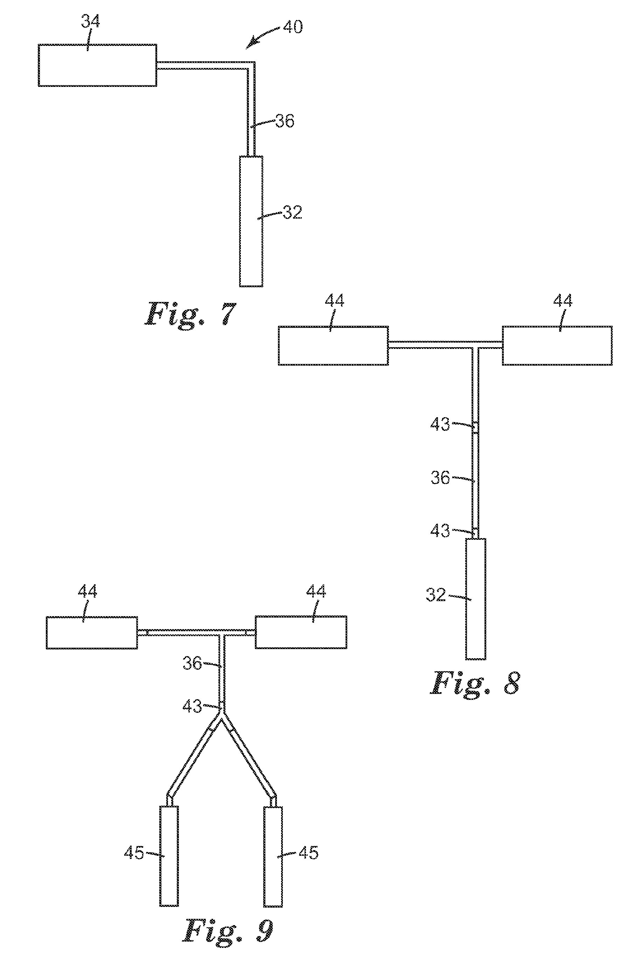

Figs. 7 to 11 illustrate modifications of the heat-transfer system of Fig. 4. Fig. 7 shows a system 40 comprising one condenser 34 only. This system can form the basic unit of a modular system to which, through the use of suitable fluid couplings, other components can be added depending on the requirements of the cabinet in which the system is to be used. For example, by providing a self-sealing fluid coupling at a point 43 in the heat pipe 36, the single condenser 34 of Fig. 7 can be replaced by two condensers 44 as shown in Fig. 8 to provide a system similar to that of Fig. 4.

Alternatively, or in addition, the single evaporator 32 of Fig. 7 can be replaced by two evaporators 45 as shown in Fig. 9 to provide a system that can be used to transfer heat from, for example, two DSLAMs within a cabinet. Similar, or alternative, modifications can be achieved by providing self-sealing couplings at other points in the heat-transfer system. Self-sealing fluid couplings are known and include, for example, couplings of the type comprising a spring-biased valve, which opens automatically when the coupling is connected and closes when the coupling is disconnected. Examples of self-sealing couplings are described in GB 698 571, US 2 753 195, US 6 499 717, and US 2004/031942. A self-sealing coupling suitable for use in the systems of Figs. 7 to 9 is available, under the trade designation "74KB", from Rectus AG of Echterdingen, Germany.

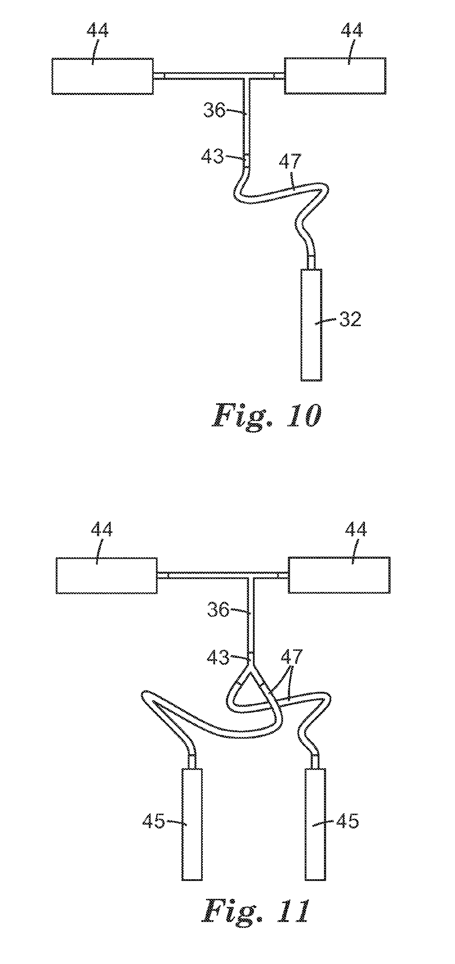

Figs. 10 and 11 show systems similar to those of Figs. 8 and 9, in which a section 47 of the/each heat pipe 36 is flexible. The flexible section 47 is advantageously provided, as shown, between the self-sealing coupling at the point 43 in the heat pipe and the evaporator(s) 32, 45. The inclusion of the flexible section 47 facilitates the positioning of the/each evaporator adjacent active equipment within a cabinet in which the heat transfer system is being used, and increases the versatility of the system.

A heat transfer system as shown in Fig. 7 (including, if required, additional components as described with reference to Figs. 8 to 11) can be installed in a new cabinet, and also in one that is already in use but in which the existing heat-removal system is becoming inadequate due to the inclusion in the cabinet of an increasing amount of active equipment.

It will be appreciated that, although Figs. 1 to 11 show a heat-management system in accordance with the invention in a telecommunications cabinet, a similar system could be used in any cabinet containing active electronic components/equipment. Also, although the cabinet shown in Figs. 1 and 2 is an outdoor cabinet, a system in accordance with the invention could likewise be used in a cabinet located inside a building in which case the heat removed from inside the cabinet would be transferred to the ambient air inside the building. In the event that the heat-generating electronic equipment within the cabinet is not already provided with a fan to generate a flow of air to cool the equipment, a suitable fan can be installed in the cabinet with the heat-management system. It should also be understood that, although the roof of the cabinet is a convenient location for the condenser(s) of the heat-management system, other locations could be used.

## Claims

1. A heat-management system for use in a cabinet containing electronic equipment that produces a flow of heated air when in operation, the system comprising:
an evaporator constructed to be positioned within the cabinet in the path of a heated air flow produced by the said equipment, to take up heat therefrom;
a condenser constructed to be positioned above the evaporator in the path of a flow of cooling air, to transfer heat to the ambient air outside the cabinet; and
a heat pipe to connect the evaporator directly to the condenser to transport heat from the evaporator to the condenser.

2. A system as claimed in claim 1, in which the evaporator, the condenser and the heat pipe form a sealed system pre-filled with a heat-transfer fluid.

3. A system as acclaimed n claim 2, in which the heat-transfer fluid comprises a hydrofluoroether, for example methyl perfluoropropyl ether.

4. A system as claimed in claim 1, in which the evaporator, the condenser, and the heat pipe are provided as separate components.

5. A system as claimed in any one of the preceding claims, in which at least part of the heat pipe is flexible whereby the relative positions of the evaporator and the condenser can be adjusted.

6. A system as claimed in any one of the preceding claims, the heat pipe comprising at least one fluid coupling enabling an additional condenser and/or and additional evaporator to be connected thereto.

7. A system as claimed in claim 6, in which the coupling is a self-sealing coupling.

8. A system as claimed in any one of the preceding claims, in which at least one of the evaporator and the condenser is a radiator.

9. A system as claimed in any one of the preceding claims, further comprising means for mounting the evaporator and/or condenser in a cabinet containing electronic equipment.

10. A method of incorporating a heat-management system as claimed in any one of the preceding claims in a cabinet containing electronic equipment that, in operation, produces a flow of heated air; the method comprising the steps of:
positioning the evaporator in the path of the heated air flow produced by the said equipment;
positioning the condenser above the evaporator in the path of a cooling air flow, to transfer heat to the ambient air outside the cabinet;
the evaporator being connected directly to the condenser by the heat pipe.

11. A method as claimed in claim 10, including the step of adjusting the position of the heat pipe.

12. A method as claimed in claim 10 or claim 11, in which the step of positioning the condenser comprises placing the condenser in the path of a cooling air flow caused by natural and/or forced convection within the cabinet.

13. A cabinet containing electronic equipment that, in operation, produces a flow of heated air, the cabinet being provided with a heat-management system as claimed in any one of claims 1 to 9 such that:
the evaporator is positioned in the path of the heated air flow produced by the said equipment, to take-up heat therefrom;
the condenser is positioned above the evaporator in the path of a flow of cooling air, to transfer heat to the ambient air outside the housing; and
the heat pipe connects the evaporator directly to the condenser to transport heat from the evaporator to the condenser.

14. A cabinet as claimed in claim 13, comprising a fan/blower operable to cause a flow of cooling air over the equipment and thereby produce the said heated air flow.

15. A cabinet as claimed in claim 13 or claim 14, in which the condenser is positioned in the path of a cooling air flow caused by natural and/or forced convection within the cabinet.
